Europäisches Patentamt

European Patent Office

Office européen des brevets

(11) Veröffentlichungsnummer: **0 215 339**
**A2**

(12) **EUROPÄISCHE PATENTANMELDUNG**

(21) Anmeldenummer: 86111741.4

(22) Anmeldetag: 25.08.86

(51) Int. Cl.⁴: **H04M 7/14** , H03H 11/48

(30) Priorität: 20.09.85 DE 3533622
27.02.86 DE 3606402

(43) Veröffentlichungstag der Anmeldung:
25.03.87 Patentblatt 87/13

(84) Benannte Vertragsstaaten:
AT BE CH DE FR GB IT LI LU NL SE

(71) Anmelder: **Siemens Aktiengesellschaft Berlin und München**
**Wittelsbacherplatz 2**
**D-8000 München 2(DE)**

(72) Erfinder: **Nijmolen, Gerrit Willem**
**Keizerdwarsweg 42**
**NL-7102 Winterswijk(NL)**
Erfinder: **Ahlmer, Hubert, Dipl.-Ing.**
**Tungerloch-Capellen 38**
**D-4423 Gescher(DE)**
Erfinder: **Pauli, Burkhard, Dipl.-Ing.**
**Hubertusstrasse 3**
**D-4270 Dordten 21(DE)**

(54) **Schaltungsanordnung, die die Funktion einer Haltedrossel in Amtssätzen von Fernsprechnebenstellenanlagen erfüllt.**

(57) Anstelle einer konventionellen Haltedrossel wird bei einer Amtsleitung, die im jeweiligen Amtssatz mit einem von der Leitung gleichstrommäßig entkoppelten Übertrager abgeschlossen ist eine "elektronische Drossel" verwendet, um den Schleifenstromfluß zu ermöglichen. Sie ist als Brückenschaltung aufgebaut, die eine niederohmige (R1, T) und eine hochohmige (R2, C2, R3) Brückenhälfte aufweist. Diejenige Diagonle, die nicht unmittelbar mit der Betriebsspannung verbunden ist, enthält zum Zwecke des Brückenabgleichs einen Differenzverstärker (TV), der ausgangsseitig mit dem Steueranschluß des in der niederohmigen Brückenhälfte angeordneten elektronischen Schalters (T) gekoppelt ist. Zur Unterdrückung eingekoppelter hochfrequenter Signale erfolgt die Zuführung der Betriebsspannung für die Brückenschaltung und/oder für den Differenzverstärker (DV) über ein Tiefpaßglied (R4, C3 bzw. R5, C1).

FIG 2

## Schaltunganordnung, die die Funktion einer Haltedrossel in Amtssätzen von Fernsprechnebenstellenanlagen erfüllt

In einer modernen Fernsprechnebenstellenanlage, in der für die Durchschaltung der einzelnen Verbindungen im Koppelfeld elektronische Koppelpunkte, z. B. in Form von CMOS-Bausteinen angewendet werden, findet zwischen der Leitungsseite und der Koppelfeldseite eine Entkoppelung durch Übertrager statt. Dies ist notwendig, da von den genannten Koppelpunkten nur kleine Signalamplituden innerhalb des Arbeitsbereiches dieser Koppelfeldbausteine durchgeschaltet werden können. Vermittels des Übertragers gelangen deshalb lediglich die Sprechwechselspannungen auf das Koppelfeld. Es sollte nun vermieden werden, daß der Schleifenstrom durch die entsprechende Übertragerwicklung fließt, da sonst in ihren Abmessungen große und damit teure Übertrager verwendet werden müßten, um die nachteilige Sättigung des Übertragerkerns zu vermeiden. Es wird deshalb der jeweilige Übertrager gleichstrommäßig von der Leitung entkoppelt und es wird gleichzeitig bei einer solchen Fernsprechnebenstellenanlage mit Amtstrennung das Fließen des Schleifenstromes durch die zwischen die beiden Leitungsadern geschaltete, sogenannte Haltedrossel, ermöglicht. Damit kann amtsseitig der Schleifenstrom weiterhin als Indikator für die Impulswahl benutzt und der jeweilige Schleifenzustand festgestellt werden. Bei solchen konventionellen Haltedrosseln ist neben ihren großen Abmessungen weiterhin von Nachteil, daß sie innerhalb des infrage kommenden Übertragungsbereiches von etwa 300 Hz bis 4 kHz eine nicht unbeträchtliche Dämpfung der zu übertragenden Niederfrequenzamplituden bewirken. Ein weiterer Nachteil einer solchen Haltedrossel ist der re lativ hohe Preis. Aufgabe der vorliegenden Erfindung ist es, eine die Funktion einer solchen Haltedrossel erfüllende Anordnung anzugeben, die die genannten Nachteile vermeidet. Dies wird dadurch erreicht, daß die Halteschaltung als Brückenschaltung mit einer niederohmigen und einer hochohmigen Brückenhälfte aufgebaut ist, daß die niederohmige Brückenhälfte in ihrem einen Brückenzweig einen Widerstand und in ihrem anderen Brückenzweig die Schaltstromstrecke eines elektronischen Schalters enthält, daß die hochohmige Brückenhälfte in ihrem einen Brückenzweig die Parallelschaltung eines Widerstandes und eine Kondensators und in ihrem anderen Brückenzweig einen Widerstand enthält und daß in der nicht an der Betriebsspannung liegenden Diagonalen der Brückenschaltung ein ausgangsseitig mit dem Steueranschluß des elektronischen Schalters verbundener Differenzverstärker angeordnet ist.

Durch die erfindungsgemäße Anordnung werden die Funktionen einer konventionellen Haltedrossel durch eine einfache, als elekronische Haltedrossel zu bezeichnende Anordnung erfüllt, die einen geringen Platzbedarf benötigt und äußerst kostengünstig zu erstellen ist. Die erfindungsgemäß aufgebaute Brückenschaltung stellt im abgeglichenen Zustand für die Wechselstromanteile einen hohen Widerstand und für die Gleichstromanteile einen geringen Widerstand dar. Die Einfügungsdämpfung ist gering, so daß die zu übertragenden Niederfrequenzamplituden nur eine unbeachtliche Dämpfung erfahren.

Gemäß einer Weiterbildung der Erfindung stellt der elektronische Schalter einen Transistor dar, der emitterseitig mit dem der niederohmigen Brückenhälfte zugehörigen Widerstand verbunden ist.

Dadurch kann vermieden werden, daß die Basis-/Emitterspannung des Transistors zu nahe am Nullpotential der Schaltungsanordnung liegt. Damit ist auch beim Einsatz von als Differenzverstärker geschalteten integrierten Operationsverstärkern in jedem Fall sichergestellt, daß die Steuerspannung für die mit dem Ausgang des Differenzverstärkers verbundene Basis des Transistors von diesem geliefert werden kann. Abhängig von der Art des jeweils eingesetzten Transistors ist -bezogen auf die Kollektor-/Emitteranschlüsse -die für den normalen Betriebsfall erforderliche Polung der Betriebsspannung vorzunehmen.

Eine weitere Ausgestaltung der Erfindung sieht vor, daß die Zuführung der Betriebsspannung für die Brückenschaltung und/oder für den Differenzverstärker über ein Tiefpaßglied erfolgt. Damit werden eventuell eingekoppelte hochfrequente Signale abgeblockt. Es kann dadurch auch keine Demodulation von eingekoppelten amplitudenmodulierten Hochfrequenzsignalen stattfinden, so daß eine ansonsten mögliche Beeinträchtigung durch nicht unmittelbar mit der betreffenden Gesprächsverbindung in Zusammenhang stehenden Sprachinformationen unterbleibt.

Die Erfindung wird anhand der Figuren näher beschrieben.

Die Fig. 1 zeigt grundsätzlich die Anwendung der erfindungsgemäßen Anordnung in einem Amtssatz einer Fernsprechnebenstellenanlage und

Fig. 2 den schaltungstechnischen Aufbau der als elektronische Haltedrossel einsetzbaren erfindungsgemäßen Anordnung.

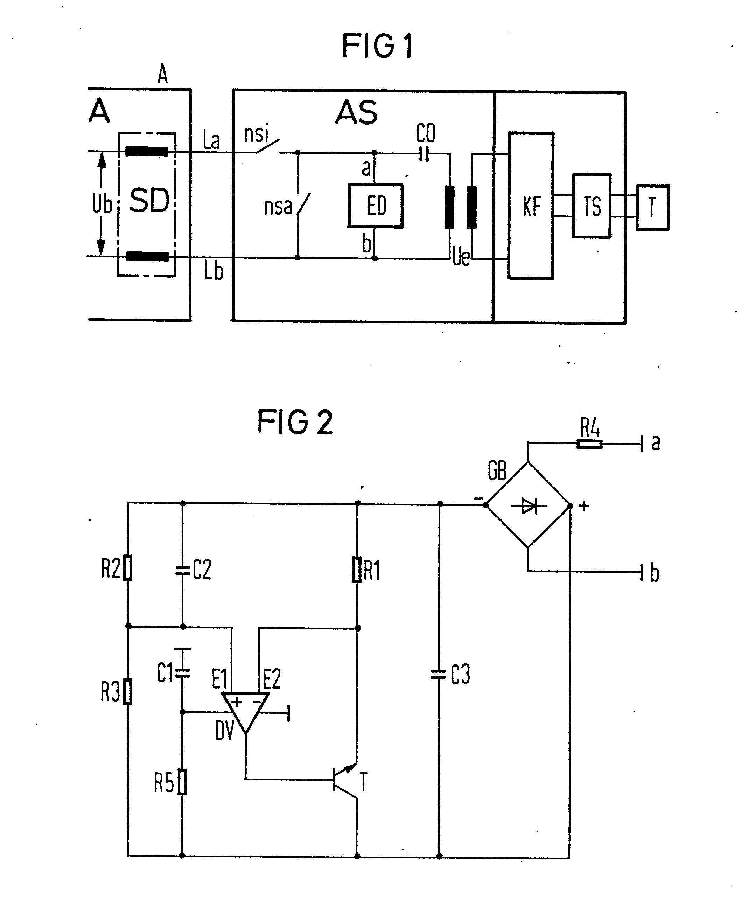

In der Fig. 1 sind lediglich die zum Verständnis der Erfindung notwendigen Bauelemente dargestellt. Der Amtssatz AS einer Fernsprechnebenstellenanlage ist über die beiden Adern La und Lb einer Verbindungsleitung mit einem Fernsprechamt A verbunden. Die Speisespannung Ub wird bekannterweise über die Speisedrossel SD an das Leitungsadernpaar angelegt. Das Koppelfeld KF der Fernsprechnebenstellenanlage soll aus integrierten Baueinheiten, beispielsweise CMOS-Bausteinen aufgebaut sein. Da über ein solches Koppelfeld lediglich die Sprechwechselspannungen geschaltet werden können, um unter Einbeziehung einer Teilnehmerschaltung TS beispielsweise die Verbindung eines Amtsteilnehmers mit einer Teilnehmerstation Tn der Nebenstellenanlage herzustellen, wird durch den Übertrager Ue eine sogenannte Amtstrennung vorgenommen. Durch den Kondensator CO wird die Primärwicklung des Übertragers Ue gleichstrommäßig entkoppelt, um eine Sättigung des Übertragerkernes zu vermeiden. Der Gleichstromfluß wird durch die zwischen die Leitungsadern geschaltete Anordnung ED, die eine Halteschaltung in Form einer elektronischen Drossel bildet, aufrechterhalten. Die im Amtssatz AS dargestellten Kontakte nsi und nsa werden bei einer abgehenden Impulswahl aufgrund von Wahlinformationen, die von einem Teilnehmer abgegeben werden, betätigt. Diese Betätigung wird unter Einschaltung von zugehörigen Relais aufgrund der aufgenommenen Wahlinformationen von einer nicht weiter dargestellten Steuereinheit veranlaßt.

In der Fig. 2 ist die erfindungsgemäße Anordnung, die anstelle einer konventionellen Haltedrossel als Halteschaltung in der geschilderten Weise zu verwenden ist, dargestellt. Über die Anschlußpunkte a und b erfolgt die Anschaltung an die mit dem gleichen Bezugszeichen a bzw. b versehenen Schaltungspunkte der Fig. 1. Die Anordnung, die die Funktion einer Haltedrossel erfüllt, ist in Form einer Brückenschaltung aufgebaut, die eine niederohmige und eine hochohmige Brückenhälfte aufweist. Die niederohmige Brückenhälfte besteht im Ausführungsbeispiel aus einem Widerstand R1 und einem Transistor vom npn-Typ. Als Transistor T könnte in gleicher Weise ein Transistor vom pnp-Typ verwendet werden. Es muß dann nur jeweils die für den einzelnen Transistortyp notwendige Polung der Betriebsspannung erfolgen. Die hochohmige Brückenhälfte besteht aus der Parallelschaltung eines Widerstandes R2 und eines Kondensators C2 und einem damit in Reihe liegenden Widerstand R3. Die Widerstandswerte der Widerstände R2 und R3 sind erheblich größer als der Widerstandswert des Widerstandes R1. In der nicht an der Betriebsspannung anliegenden Diagonalen der Brückenanordnung ist mit seinen Eingängen E1 und E2 ein Differenzverstärker DV eingeschaltet, dessen Ausgang mit der Basis des in der niederohmigen Brückenhälfte liegenden Transistors T verbunden ist. Um sicherzustellen, daß die Steuerspannung für die Basis des Transistors vom Verstärker geliefert werden kann, liegt der Emitter des Transistors nicht unmittelbar an einem Pol der Betriebsspannung, sondern er ist mit dem Widerstand R1 verbunden.

Im abgeglichenen Zustand der Brückenschaltung gilt für Gleichstrom, daß das Produkt aus den Widerstandswerten der Widerstände R1 und R3 gleich dem Produkt aus den Widerstandswerten des Widerstandes R2 und dem Widerstandswert der Kollektor-/Emitter-Strecke des Transistors T ist. Bezeichnet man das Verhältnis der beiden hochohmigen Widerstände R3 zu R2 mit k, so ergibt sich, daß der Widerstandswert des Transistors gleich dem Produkt von k mal dem Widerstandswert des Widerstandes R1 ist. Aufgrund der Hochohmigkeit des aus den Widerständen R2 und R3 sowie dem Kondensator C2 bestehenden Brückenhälfte wird der Gleichstromwiderstand der Brücke hauptsächlich durch den Widerstand R1 und durch den Widerstandswert des Transistors T bestimmt. Da sich der Widerstandswert der Kollektor-/Emitter-Strecke des Transistors T für langsame Änderungen, d.h. auch für Gleichstrom, wie ein ohm'scher Widerstand verhält, wird der Widerstand für Gleichstromkomponenten bestimmt durch den Wirderstand R1 und durch das Verhältnis der beiden Widerstände R3 und R2. Durch entsprechende Änderungen ist daher jeder gewünschte Widerstandswert für Gleichstromkomponenten einstellbar.

Für Wechselstromkomponenten gilt bei abgeglichener Brückenanordnung, daß das Produkt der Widerstandswerte der beiden Widerstände R1 und R3 gleich dem Produkt des sich aus der Parallelschaltung des Kondensators C2 und des Widerstandes R2 ergebenden Wechselstromwiderstandes und dem Wechselstromwiderstandes des Transistors T ist. Aufgrund der Dimensionierung der Schaltung ist der Wechselstromwiderstand der Parallelschaltung des Widerstandes R2 mit dem Kondensator C2 innerhalb des interessierenden Übertragungsbereiches relativ klein. Der hohe Widerstand der Kollektor-/Emitter-Strecke des Transistors T für die Weckselstromkomponente wird also hauptsächlich durch den sehr hochohmigen Widerstand R3 bestimmt. Die Brückenanordnung verursacht demnach nur eine sehr geringe Dämpfung der zu übertragenden Niederfrequenzamplituden. Die Impedanz des Differenzverstärkers DV ist praktisch vernachlässigbar.

Die Gleichrichterbrücke GB, die aus normalen Dioden und Zenerdioden bestehen kann, gewährleistet einen Überspannungsschutz und einen Verpolungsschutz. Zur Verbesserung der Überspannungsfestigkeit kann zusätzlich ein Widerstand R4 vorgesehen sein. Dieser Widerstand R4 bildet gleichzeitig mit dem Kondensator C3 ein Tiefpaßglied. Ein weiteres Tiefpaßglied, das aus dem Widerstand R5 und dem Kondensator C1 besteht, liegt in der Betriebsspannungszuführung für den Differenzverstärker DV. Diese Tiefpaßschaltungen blocken die Versorgungsspannung des Differenz verstärkers gegen hochfrequente Signale ab, die über die Adern La bzw. Lb der Amtsleitung die durch die beschriebene Brückenanordnung realisierte Halteschaltung erreichen können. Dies ist insbesondere dann von Bedeutung, wenn es sich bei den eingekoppelten Signalen z. B. um amplitudenmodulierte Hochfrequenzsignale handelt. Dadurch werden ansonsten aufgrund von Demodulationen der Hochfrequenzsignale auftretende Störungen unterbunden.

**Ansprüche**

1. Schaltungsanordnung, die die Funktion einer Haltedrossel in Amtssätzen von Fernsprechnebenstellenanlagen erfüllt, **dadurch gekennzeichnet,** daß sie als Brückenschaltung mit einer niederohmigen (R1, T) und einer hochohmigen (R2, C2; R3) Brückenhälfte aufgebaut ist, daß die niederohmige Brückenhälfte in ihrem einen Brückenzweig einen Widerstand (R1) und in ihrem anderen Brückenzweig die Schaltstromstrecke eines elektronischen Schalters (T) enthält, daß die hochohmige Brückenhälfte in ihrem einen Brückenzweig die Parallelschaltung eines Widerstandes (R2) und eines Kondensators (C2) und in ihrem anderen Brückenzweig einen Widerstand (R3) enthält und daß in der nicht an der Betriebsspannung liegenden Diagonalen der Brückenschaltung ein ausgangsseitig mit dem Steueranschluß des elektronischen Schalters (T) verbundener Differenzverstärker (DV) angeordnet ist.

2. Schaltungsanordnung nach Anspruch 1, **dadurch gekennzeichnet,** daß der elektronische Schalter einen Transistor (T) darstellt, der emitterseitig mit dem der niederohmigen Brückenhälfte zugehörigen Widerstand (R1) verbunden ist.

3. Schaltungsanordnung nach Anspruch 1 bzw. Anspruch 2, **dadurch gekennzeichnet,** daß die Zuführung der Betriebsspannung für die Brückenschaltung und/oder für den Differenzverstärker (DV) über ein Tiefpaßglied (R4,C3;R5,C1) erfolgt.

# FIG 1

# FIG 2